(19)

Europäisches
Patentamt
European
Patent Office
Office européen
des brevets

(11) **EP 2 560 278 A1**

(12) **EUROPEAN PATENT APPLICATION**

(43) Date of publication:
**20.02.2013 Bulletin 2013/08**

(51) Int Cl.:
***H03F 1/02*** (2006.01)

(21) Application number: **11180725.1**

(22) Date of filing: **09.09.2011**

| | |
|---|---|
| (84) Designated Contracting States:<br>**AL AT BE BG CH CY CZ DE DK EE ES FI FR GB<br>GR HR HU IE IS IT LI LT LU LV MC MK MT NL NO<br>PL PT RO RS SE SI SK SM TR**<br>Designated Extension States:<br>**BA ME**<br><br>(30) Priority: **19.08.2011 TW 100129680** | (71) Applicant: **Chief Land Electronic Co. Ltd.<br>Wugu Dist., New Taipei City 248 (TW)**<br><br>(72) Inventor: **Li, Hsu-Yu<br>New Taipei City (TW)**<br><br>(74) Representative: **Karakatsanis, Georgios<br>Haft - Karakatsanis<br>Siegesstrasse 13<br>80802 München (DE)** |

(54) **Power Generating System**

(57) The present invention is directed to a power generating system. At least one signal tracing unit receives an input signal, according to which a tracing signal is generated, wherein the waveform of the tracing signal traces the wave peak of the input signal. At least one DC to DC converter receives the tracing signal, according to which a power supply is generated.

EP 2 560 278 A1

Description

## BACKGROUND OF THE INVENTION

### 1. FIELD OF THE INVENTION

The present invention generally relates to a power generating system, and more particularly to a power generating system capable of tracing an input signal.

### 2. DESCRIPTION OF RELATED ART

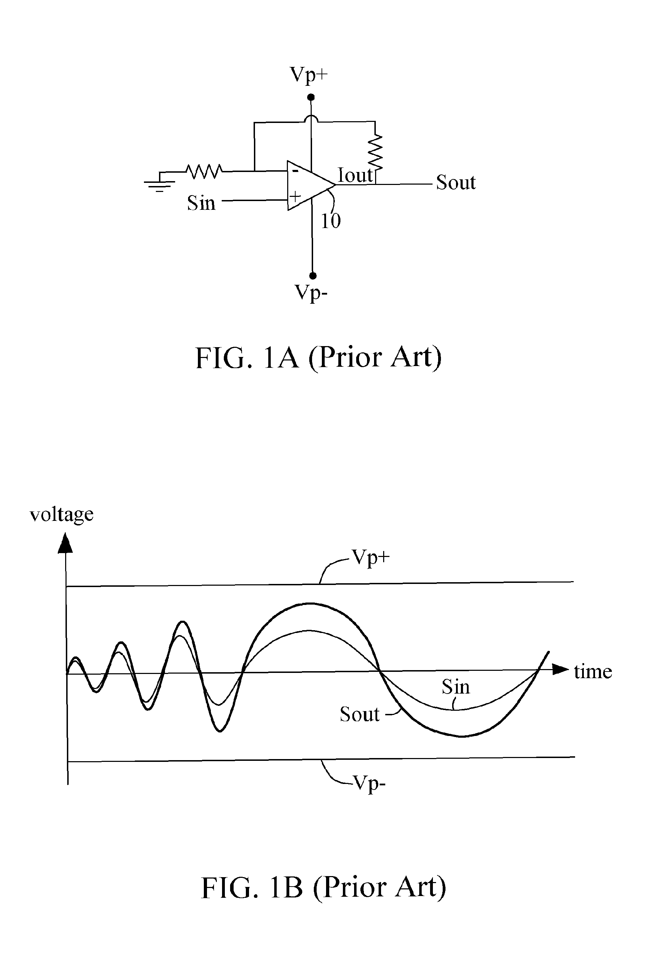

An amplifier is a circuit that amplifies the power of a signal, and is commonly used in an electronic system. FIG. 1A shows a conventional amplifier utilizing an operational amplifier 10, which is supplied with power supplies Vp+ and Vp-. Referring to signal waveforms shown in FIG. 1B, the power supplies Vp+ and Vp- of the conventional amplifier have constant values. In other words, the power supplies Vp+ and Vp- are fixed no matter how an input signal Sin and an output signal Sout change.

The efficiency of the amplifier shown in FIG. 1A is low. Specifically speaking, when the amplitude of the output signal is positive, the consumed power of the amplifier is Iout*((Vp+)-(Sout)); when the amplitude of the output signal is negative, the consumed power of the amplifier is Iout*((-Vp-)+(Sout)). The consumed power mentioned above will be converted to heat energy. As battery capacity of a portable electronic device is limited, the operating time of the battery may be lengthened if the consumed power is reduced. Moreover, as the lack of space in the portable electronic device makes it difficult to dissipate heat, the heat-dissipating device of the portable electronic device may be simplified if the consumed power is reduced.

Accordingly, a need has arisen to propose a novel power generating scheme for adaptively generating a power supply in order to reduce the consumed power.

## SUMMARY OF THE INVENTION

In view of the foregoing, it is an object of the embodiment of the present invention to provide a power generating system for providing an amplifier with a required power supply, which adaptively changes according to an input signal, therefore substantially reducing the consumed power, lengthening the operating time of a battery, and reducing heat generation and dissipation.

According to one embodiment, the power generating system includes at least one signal tracing unit and at least one DC to DC converter. The signal tracing unit receives an input signal, according to which a tracing signal is generated, wherein a waveform of the tracing signal traces a wave peak of the input signal. The DC to DC converter receives the tracing signal, according to which a power supply is generated.

## BRIEF DESCRIPTION OF THE DRAWINGS

FIG. 1A shows a conventional amplifier utilizing an operational amplifier;
FIG. 1B shows related signal waveforms of FIG. 1A;
FIG. 2A shows a block diagram illustrative of a power generating system for providing an amplifier with required power supply according to one embodiment of the present invention;
FIG. 2B shows a block diagram illustrative of a power generating system according to another embodiment of the present invention;
FIG. 2C shows related signal waveforms of FIG. 2B;
FIG. 3A shows a circuit diagram illustrative of a power generating system according to a first preferred embodiment of the present invention;
FIG. 3B shows a circuit equivalent to the first signal tracing unit of FIG. 3A;
FIG. 3C shows a power generating system according to a modified first embodiment of the present invention;
FIG. 3D shows related signal waveforms of FIG. 3C;
FIG. 4 shows a circuit diagram illustrative of a power generating system according to a second preferred embodiment of the present invention; and
FIG. 5 shows a circuit diagram illustrative of a power generating system according to a third preferred embodiment of the present invention.

## DETAILED DESCRIPTION OF THE INVENTION

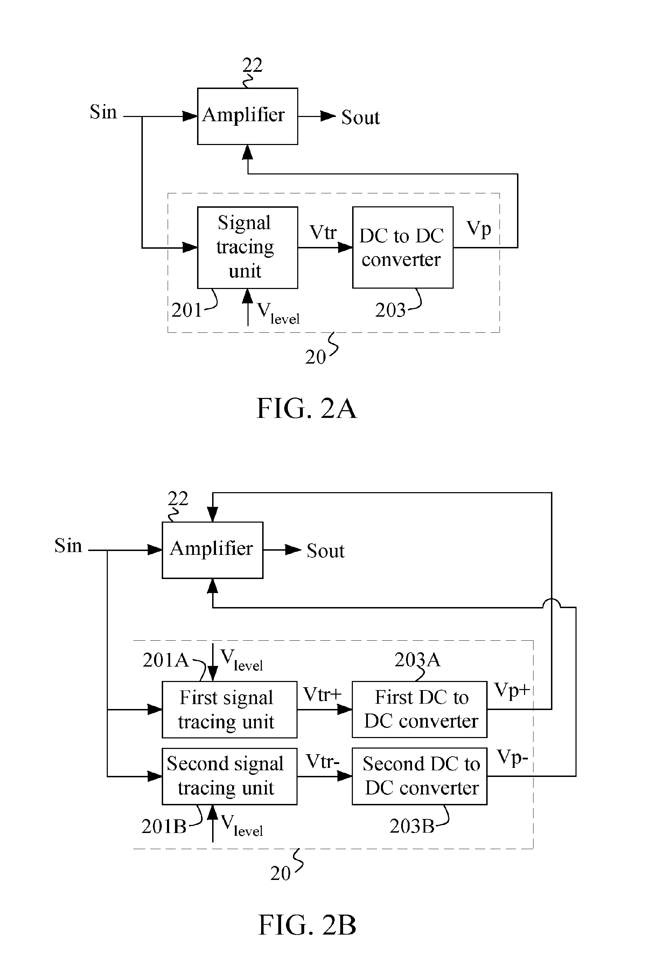

FIG. 2A shows a block diagram illustrative of a power generating system 20 for providing an amplifier 22 with a required power supply Vp according to one embodiment of the present invention. The amplifier 22 amplifies an input signal Sin to generate an output signal Sout. The amplifier 22 may have a variety of configurations such as, but not limited to, the amplifier shown in FIG. 1A.

In the embodiment, the power generating system 20 primarily includes a signal tracing unit 201 and a DC (direct-current) to DC converter 203. Specifically, the signal tracing unit 201 receives an input signal of the amplifier 22 and accordingly generates a tracing signal Vtr, wherein the waveform of the tracing signal Vtr traces the wave peak of the input signal Sin. The DC to DC converter 203 receives the tracing signal Vtr, according to which a power supply Vp is generated for providing to the amplifier 22. In the embodiment, the power supply Vp is referred to a power supply voltage. Further, the signal tracing unit 201 receives a (positive-valued) operating voltage $V_{level}$ to ensure that the generated power supply Vp has an absolute value not being less than a minimum working voltage Vmin. Moreover, when the input signal Sin has insufficient driving capability to drive the signal tracing unit 201, resulting in distortion in the input signal Sin, the driving capability of the input signal Sin, therefore, may be enhanced before transferring the input signal Sin to the signal tracing unit 201.

The power generating system 20 as shown in FIG. 2A generates the single power supply Vp according to the single tracing signal Vtr. The power generating system 20 as shown in FIG. 2B, nevertheless, generates two tracing signals Vtr+ and Vtr-, according to which two power supplies Vp+ and Vp- are generated. Specifically, a first signal tracing unit 201A and a second signal tracing unit 201B receive the input signal Sin of the amplifier 22, and accordingly generate a first tracing signal Vtr+ and a second tracing signal Vtr-, respectively, and the waveforms of the first/second tracing signals Vtr+/Vtr- trace a positive wave peak and a negative wave peak of the input signal Sin, respectively. A first DC to DC converter 203A and a second DC to DC converter 203B receive the first tracing signal Vtr+ and the second tracing signal Vtr-, respectively, according to which the first power supply Vp+ and the second power supply Vp- are generated and provided to the amplifier 22.

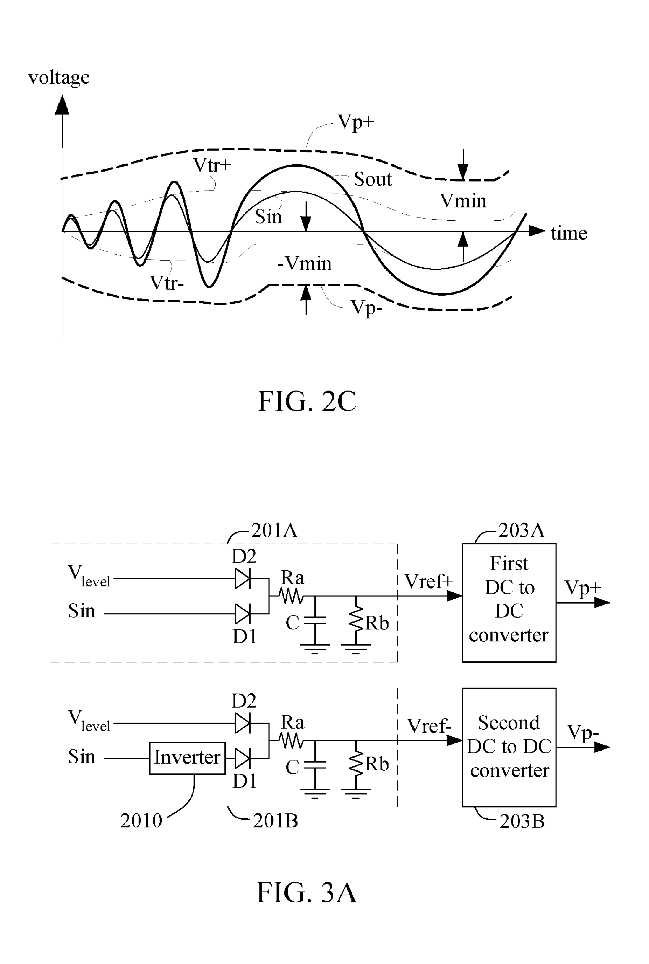

FIG. 2C shows related signal waveforms of FIG. 2B. As shown in FIG. 2C, the first tracing signal Vtr+ and the second tracing signal Vtr- trace the wave peak of the input signal Sin. Regarding a low frequency part of the input signal Sin (as shown to the right-hand side of the figure), the amplitudes of the first/second tracing signals Vtr+/Vtr- are slightly lowered between wave peaks due to discharging in the circuit. It is noted that the first/second tracing signals Vtr+/Vtr- may be lower (or higher) than the wave peak of the input signal Sin, although the first/second tracing signals Vtr+/Vtr- are depicted, in the drawing, to be tangential to the input signal Sin at the peaks. Moreover, when the positive sinusoidal wave of the input signal Sin has a value lower than the operating voltage $V_{level}$, the first power supply Vp+ can be kept higher than the minimum voltage Vmin; when the absolute value of the negative sinusoidal wave of the input signal Sin has a value lower than the operating voltage $V_{level}$, the second power supply Vp- can be kept lower than minus the minimum voltage Vmin (i.e., -Vmin). As the first/second power supplies Vp+/Vp- provided to the amplifier 20 adaptively change according to the input signal Sin, a substantive consumed power may be saved, the operating time of a battery may be substantially lengthened, and heat generation and dissipation may be substantially reduced. The structure of FIG. 2A or FIG. 2B may be implemented by a variety of analog or digital circuits, some of which will be introduced below as preferred embodiments.

FIG. 3A shows a circuit diagram illustrative of a power generating system 20 according to a first preferred embodiment of the present invention. In the embodiment, the first/second tracing signals Vtr+/Vtr- are first/second reference voltages Vref+/Vref- of the first/second DC to DC converters 203A/203B, respectively. The generated first/second power supplies Vp+/Vp- have the following relationship:

$$Vp+=(Vref+)*gain,$$

$$Vp-=(Vref-)*gain.$$

The first signal tracing unit 201A of the embodiment includes a first diode D1, whose anode is coupled to the input signal Sin for passing the positive sinusoidal wave of the input signal Sin. Series-connected capacitor C and resistor Ra, acting as an integrator, are coupled between the cathode of the first diode D1 and ground, therefore generating the first reference voltage Vref+. Further, a resistor Rb parallel connected with the capacitor C is used for discharging, and may be used to determine how fast the first reference voltage Vref+ traces the input signal Sin. Moreover, the first signal tracing unit 201A may include a second diode D2, whose anode is coupled to receive the operating voltage $V_{level}$, and its cathode is coupled to the integrator Ra/C. When the input signal Sin is lower than the operating voltage $V_{level}$, the second diode D2 is turned on (while the first diode D 1 is shut off), and the first reference voltage Vref+ is kept at the operating voltage $V_{level}$ and the first power supply Vp+ is kept higher than the minimum working voltage Vmin. The second signal tracing unit 201B has a structure similar to that of the first signal tracing unit 201A, but further includes an inverter 2010 for inverting the negative waveform of the input signal Sin, and then following the same operating principle of the first signal tracing unit 201A for generating the second reference voltage Vref-.

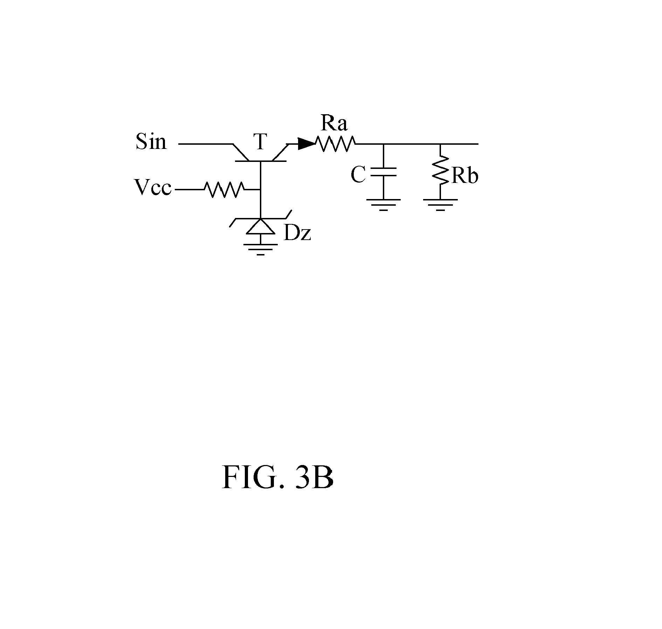

FIG. 3B shows a circuit equivalent to the first signal tracing unit 201A of FIG. 3A. In the embodiment, the first signal tracing unit 201A includes a transistor T, whose input node (i.e., the collector electrode) is coupled to receive the input signal Sin, its output node (i.e., the emitter electrode) is coupled to the capacitor C and the resistor Ra (i.e., the integrator). The control node (i.e., the base electrode) is coupled to a Zener diode Dz, which has a breakdown voltage approximately equal to the operating voltage $V_{level}$ plus base-to-emitter voltage $V_{BE}$ of the transistor T.

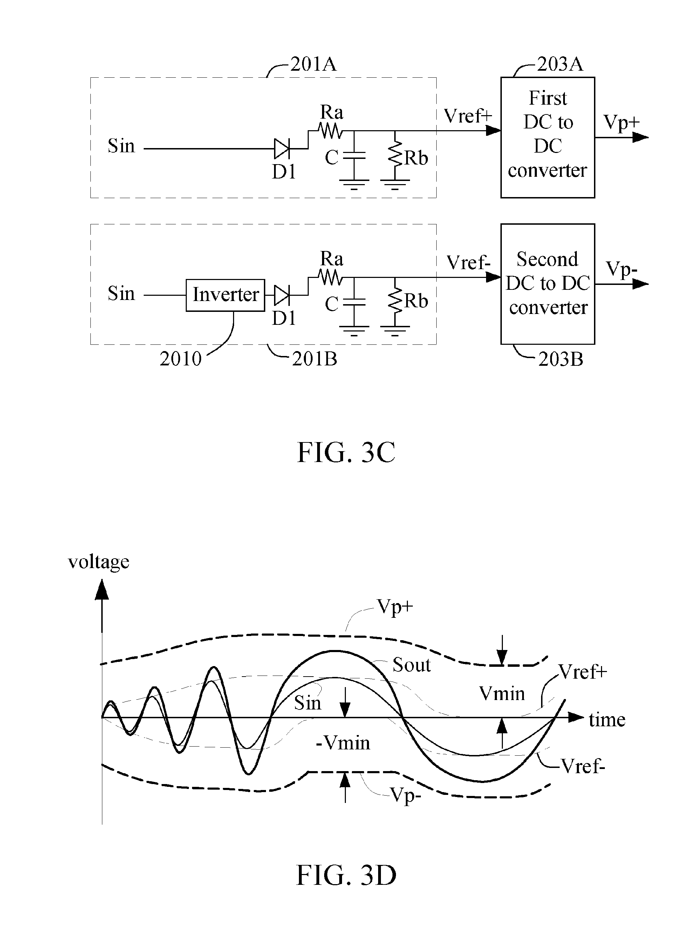

FIG. 3C shows a power generating system 20 according to a modified first embodiment of the present invention, and FIG. 3D shows related signal waveforms of FIG. 3C. Compared to the embodiment of FIG. 3A, the present embodiment omits the operating voltage $V_{level}$ and the associated second diode D2. Nevertheless, the first/second DC to DC converters 203A/203B each internally includes a bias circuit for keeping the first power supply Vp+ higher than the minimum working voltage Vmin and keeping the second power supply Vp- less than minus the minimum working voltage (i.e., -Vmin), when the absolute value of the first/second reference voltage Vref+/Vref- is less than the operating voltage.

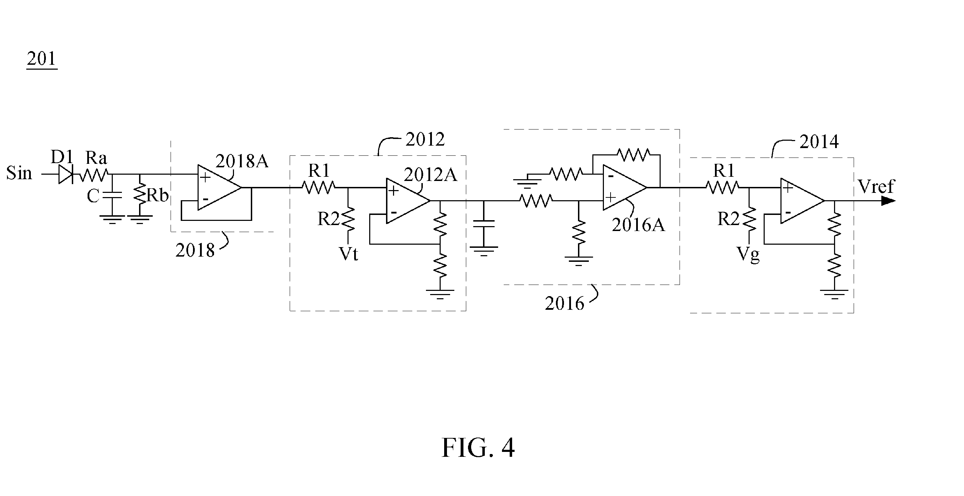

FIG. 4 shows a circuit diagram illustrative of a power generating system 20 according to a second preferred embodiment of the present invention. Only the signal tracing unit 201 is shown while other portion of the system is omitted. Similar to the first preferred embodiment (FIG. 3A), in the present embodiment, the signal tracing unit 201 includes the first diode D1, whose anode is coupled to receive the input signal Sin for passing the positive sinusoidal wave of the input signal Sin, and series-connected capacitor C and resistor Ra, acting as an integrator, are coupled between the cathode of the first diode D1 and ground. The embodiment employs a DC offset adjusting circuit 2012 to ensure that the generated power supply Vp is not less than the minimum working voltage Vmin. Specifically, the DC offset adjusting circuit 2012 includes a voltage divider made of a resistor R1 and a resistor R2. One end of the voltage divider is, indirectly, coupled to receive the output of the integrator, and another end of the voltage divider is coupled to an adjusting voltage Vt. The generated divided voltage is amplified by a non-inverting amplifier made of an operational amplifier 2012A.

The signal tracing unit 201 of the embodiment may use more than one DC offset adjusting circuit such as the block 2014, in which an adjusting voltage Vg is used. According to further circuit design considerations, the signal tracing unit 201 of the embodiment may further include other circuits such as a non-inverting amplifier 2016 made of an operational amplifier 2016A for amplifying/reducing signal; or a unity-gain buffer amplifier 2018 made of the an operational amplifier 2018A for improving current driving capability.

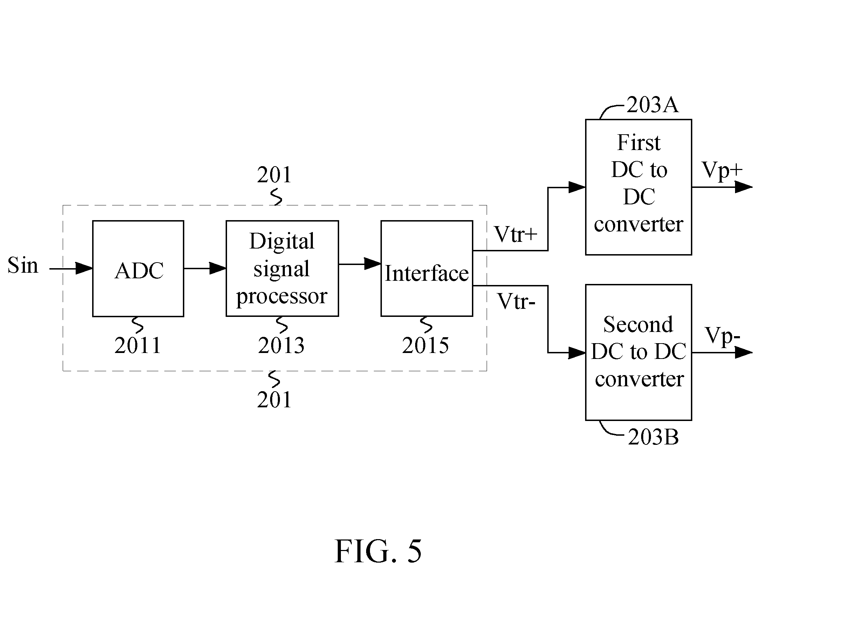

FIG. 5 shows a circuit diagram illustrative of a power generating system 20 according to a third preferred embodiment of the present invention. In the embodiment, the signal tracing unit 201 includes an analog-to-digital converter (ADC) 2011 for converting the input signal Sin to a digital signal. The converted digital signal is transferred to a digital signal processor 2013 for generating the first/second tracing signals Vtr+/Vtr-, which are then provided to the first/second DC to DC converter 203A/203B, respectively. The digital signal processor 2013 may be used to ensure that the absolute value of the generated power supply Vp is not less than the minimum voltage Vmin according to the inputted or preset operating voltage $V_{level}$.

If the first/second DC to DC converters 203A/203B each has an analog input interface, an additional digital-to-analog converter (DAC), acting as a signal interface 2015, is required and disposed between the digital signal processor 2013 and the first/second DC to DC converters 203A/203B. If the first/second DC to DC converters 203A/203B each has a digital input interface, an additional digital signal interface 2015 may additionally be used and disposed between the digital signal processor 2013 and the first/second DC to DC converters 203A/203B. The digital signal interface 2015 may be General Purpose Input/Output (GPIO), Inter-Integrated Circuit (I2C), Serial Peripheral Interface (SPI) or Universal Asynchronous Receiver/Transmitter (UART). The ADC 2011 or the signal interface 2015 may be integrally manufactured with the digital signal processor 2013 within a chip or a package, or may be separately manufactured or packaged.

Although specific embodiments have been illustrated and described, it will be appreciated by those skilled in the art that various modifications may be made without departing from the scope of the present invention, which is intended to be limited solely by the appended claims.

## Claims

1. A power generating system, comprising:

   at least one signal tracing unit configured to receive an input signal, according to which a tracing signal is generated, wherein a waveform of the tracing signal traces a wave peak of the input signal; and
   at least one DC to DC converter configured to receive the tracing signal, according to which a power supply is generated.

2. The system of claim 1, wherein the signal tracing unit further receives an operating voltage, which is used to ensure that an absolute value of the generated power supply is not less than a minimum working voltage.

3. The system of claim 1, wherein the at least one signal tracing unit includes a first signal tracing unit and a second signal tracing unit, and the at least one DC to DC converter includes a first DC to DC converter and a second DC to DC converter; wherein the first signal tracing unit generates a first tracing signal according to the input signal, and the second signal tracing unit generates a second tracing signal according to the input signal; the first DC to DC converter generates a first power supply according to the first tracing signal, and the second DC to DC converter generates a second power supply according to the second tracing signal.

4. The system of claim 1, wherein the tracing signal is a reference voltage of the DC to DC converter, and the generated power supply has a relationship with the reference voltage as follows:

   the power supply=the reference voltage*gain.

5. The system of claim 4, wherein the signal tracing unit comprises:

   a first diode having an anode coupled to the input signal for passing a positive sinusoidal waveform of the input signal; and
an integrator coupled to a cathode of the first diode for generating the reference voltage.

6. The system of claim 5, wherein the integrator comprises a capacitor and a resistor that are serial connected, wherein the integrator is coupled between the cathode of the first diode and ground.

7. The system of claim 5, wherein the signal tracing unit comprises:

a second diode having an anode coupled to an operating voltage, and a cathode coupled to the integrator;

wherein the second diode is turned on to keep the reference voltage at the operating voltage when the input signal is less than the operating voltage.

8. The system of claim 4, wherein the signal tracing unit includes:

a transistor having an input node coupled to the input signal;
a Zener diode coupled to a control node of the transistor, wherein the Zener diode has a breakdown voltage approximately equal to an operating voltage plus a voltage drop between the control node and an output node; and
an integrator coupled to the output node of the transistor for generating the reference voltage.

9. The system of claim 4, wherein the signal tracing unit comprises:

a first diode having an anode coupled to the input signal for passing a positive sinusoidal waveform of the input signal;
an integrator coupled to a cathode of the first diode; and
at least one DC offset adjusting circuit configured to ensure that the generated power supply is not less than a minimum voltage.

10. The system of claim 9, wherein the DC offset adjusting circuit comprises:

a voltage divider having one end coupled to an output of the integrator, and another end coupled to an adjusting voltage; and
a non-inverting amplifier configured to receive a divided voltage from the voltage divider.

11. The system of claim 1, wherein the signal tracing unit comprises:

an analog-to-digital converter configured to convert the input signal to a digital signal;
a digital signal processor configured to receive the digital signal, according to which the tracing signal is generated in a digital domain; and
an interface configured to transfer the tracing signal to the DC to DC converter.

12. The system of claim 11, wherein the digital signal processor is further used to ensure that an absolute value of the generated power supply is not less than the minimum working voltage according an inputted or preset operating voltage.

13. The system of claim 11, wherein the interface comprises a digital-to-analog converter (DAC).

14. The system of claim 11, wherein the interface comprises a digital interface.

15. The system of claim 14, wherein the digital interface comprises one of the following: General Purpose Input/Output (GPIO), Inter-Integrated Circuit (I$^2$C), Serial Peripheral Interface (SPI) and Universal Asynchronous Receiver/Transmitter (UART).

Vp+

Iout ——Sout

Sin

10

Vp-

## FIG. 1A (Prior Art)

voltage

Vp+

time

Sin

Sout

Vp-

## FIG. 1B (Prior Art)

6

FIG. 2A

FIG. 2B

FIG. 2C

FIG. 3A

FIG. 3B

FIG. 3C

FIG. 3D

FIG. 4

FIG. 5

Europäisches
Patentamt

European
Patent Office

Office européen
des brevets

# EUROPEAN SEARCH REPORT

Application Number

EP 11 18 0725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 454 179 B1 (LEE JONGSOO [US]) 18 November 2008 (2008-11-18) * column 1, line 62 - column 3, line 22 * * column 4, line 6 - column 7, line 30; figures 3,4,6,10 * | 1-15 | INV. H03F1/02 |
| X | GB 2 455 066 A (SAMSUNG ELECTRONICS CO LTD [KR]) 3 June 2009 (2009-06-03) * page 3, line 4 - page 5, line 34 * * page 10, line 35 - page 13, line 31 * * page 19, lines 21-33; figures 1,11 * | 1-15 | |
| X | US 2007/024372 A1 (HAGEN RODNEY [US]) 1 February 2007 (2007-02-01) * paragraphs [0001], [0053] - [0059]; figure 10 * | 1-15 | |

TECHNICAL FIELDS
SEARCHED     (IPC)

H03F

The present search report has been drawn up for all claims

| Place of search | Date of completion of the search | Examiner |
|---|---|---|
| The Hague | 16 November 2011 | Goethals, Filip |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**

EP 11 18 0725

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2011

| Patent document cited in search report | | Publication date | Patent family member(s) | Publication date |
|---|---|---|---|---|
| US 7454179 | B1 | 18-11-2008 | NONE | |
| GB 2455066 | A | 03-06-2009 | NONE | |
| US 2007024372 | A1 | 01-02-2007 | NONE | |

EPO FORM P0459